# EUROPÄISCHE PATENTSCHRIFT

(11) **EP 0 316 705 B1**
(45) Veröffentlichungstag und Bekanntmachung des Hinweises auf die Patenterteilung: **30.03.1994**
(21) Anmeldenummer: 88118536.7
(22) Anmeldetag: 08.11.1988
(51) Int. Cl.: G03F 7/075, G03F 7/021

(54) **Lichtempfindliche Druckplatte für den wasserlosen Offsetdruck**
Light sensitive printing plate for dry lithographic printing
Plaque d'impression photosensible pour l'impression lithographique à sec

(30) Priorität: 16.11.1987 DE 3738863
(43) Veröffentlichungstag der Anmeldung: 24.05.1989
(73) Patentinhaber: HOECHST AKTIENGESELLSCHAFT, 65926 Frankfurt am Main (DE)
(72) Erfinder: Schlosser, Hans-Joachim, Dr., D-6200 Wiesbaden (DE); Gersdorf, Jochim, Dr., D-6200 Wiesbaden (DE)

(56) Entgegenhaltungen:
- EP-A- 0 211 391
- EP-A- 0 226 201
- DE-A- 2 350 211
- DE-A- 3 702 839

## Beschreibung

Die Erfindung betrifft eine lichtempfindliche Druckplatte, die für den wasserlosen Offsetdruck geeignet ist und im wesentlichen aus einem Schichtträger, einer negativ arbeitenden lichtempfindlichen Schicht und einer darüberliegenden, Druckfarbe abstoßenden Silikongummischicht besteht.

Lichtempfindliche Druckplatten der genannten Gattung, die als lichtempfindliche Verbindungen Polykondensationsprodukte aromatischer Diazoniumverbindung enthalten, sind aus der EP-A 0 226 201 bekannt. Die lichtempfindliche Schicht wird durch Belichten unlöslich und kann mit organischen Lösemittelgemischen entwickelt werden. Bei der Entwicklung werden die Bereiche der Silikongummischicht, die über den löslichen, ungehärteten Bereichen der lichtempfindlichen Schicht liegen, zusammen mit diesen löslichen Bereichen entfernt, obwohl sie selbst im Entwickler nicht löslich sind. Es ist aber erforderlich, daß der Entwickler in ausreichender Menge solche organischen Lösemittel enthält, die die Silikongummischicht anquellen und dadurch erweichen.

In der US-A 3 894 873 sind Druckplatten für den wasserlosen Offsetdruck beschrieben, die eine lichtempfindliche Schicht aus einem photopolymerisierbaren Gemisch aufweisen. Bei Belichtung polymerisiert die Schicht und vernetzt mit der darüberliegenden Silikongummischicht. Nach der Belichtung wird die Platte mit einer den Silikongummi anquellenden Flüssigkeit behandelt. An den nicht belichteten Stellen quillt der Silikongummi und kann durch Reiben entfernt werden, während er an den belichteten Stellen fest haftet. Da die photopolymerisierbare Schicht gegen Luftsauerstoff empfindlich ist und die Silikongummischicht stark sauerstoffdurchlässig ist, ist in der Regel eine für Sauerstoff undurchlässige Abdeckfolie erforderlich, die auf die Silikonschicht laminiert und nach dem Belichten abgezogen wird. Diese Folie erhöht, zusammen mit der Silikonschicht, den Abstand der lichtempfindlichen Schicht von der Bildschicht der Vorlage und mindert somit die Auflösung.

Druckplatten mit photopolymerisierbaren Schichten der vorstehend beschriebenen Art sind als solche recht lichtempfindlich. Bei der für den wasserlosen Offsetdruck vorgesehenen Ausführungsform ist jedoch eine relativ lange Belichtung erforderlich, offenbar um eine ausreichende Verankerung der Druckfarbe abweisenden Silikonschicht auf der photopolymerisierbaren Schicht zu erreichen. Eine Erhöhung der Lichtempfindlichkeit derartiger Platten wäre deshalb wünschenswert.

Es sind weiterhin Druckplatten für den Offsetdruck mittels Feuchtwasser bekannt, die lichtempfindliche Schichten aus einem Diazoniumsalz-Polykondensationsprodukt, einer radikalisch polymerisierbaren Verbindung, einem Photopolymerisationsinitiator und mindestens einem Bindemittel aufweisen. Derartige Platten sind in der GB-A 2 044 788 beschrieben. Als Vorteil wird hierbei die bessere Auflösung der Kopie gegenüber reinen photopolymerisierbaren Schichten und die erhöhte Druckauflage gegenüber solchen Schichten angegeben, die allein Diazoniumverbindungen als lichtempfindliche Substanzen enthalten. Auch ist es in bestimmten Fällen möglich, die Entwicklung mit wäßrigen Lösungen oder sogar mit reinem Wasser durchzuführen.

In der EP-A 0 167 963 ist eine ähnliche Druckplatte beschrieben, die ein Diazoniumsalz-Polykondensationsprodukt enthält, das neben Diazoniumsalzeinheiten noch solche aus von Diazoniumgruppen freien, mit Formaldehyd kondensationsfähigen Verbindungen enthält.

Die zuletzt genannten Druckplatten sind nicht für den wasserlosen Offsetdruck bestimmt und geeignet.

Aufgabe der Erfindung war es, Druckplatten für den wasserlosen Offsetdruck bereitzustellen, die eine gute Bildauflösung, eine hohe Druckauflage und zugleich eine höhere Lichtempfindlichkeit aufweisen als die bisher bekannten Druckplatten.

Die Erfindung geht aus von einer lichtempfindlichen Druckplatte für den wasserlosen Offsetdruck aus einem Schichtträger, einer lichtempfindlichen, ein Diazoniumsalz-Polykondensationsprodukt enthaltenden Schicht und einer darüberliegenden, Druckfarbe abstoßenden Silikongummischicht.

Die erfindungsgemäße Druckplatte ist dadurch gekennzeichnet, daß die lichtempfindliche Schicht ferner eine radikalisch polymerisierbare Verbindung mit mindestens einer endständigen ethylenisch ungesättigten Gruppe und einem Siedepunkt bei Normaldruck oberhalb 100 °C und einen unter Einwirkung aktinischer Strahlung Radikale bildenden Polymerisationsinitiator enthält.

Die Bestandteile der lichtempfindlichen Schicht sind im wesentlichen in den EP-A 0 167 963 und 0 211 391 beschrieben.

Als Diazoniumsalz-Polykondensationsprodukte sind Kondensationsprodukte kondensationsfähiger aromatischer Diazoniumsalze, z. B. von Diphenylamin-4-diazoniumsalzen, mit Aldehyden, bevorzugt Formaldehyd, geeignet. Mit besonderem Vorteil werden Mischkondensationsprodukte verwendet, die außer den Diazoniumsalzeinheiten noch andere, nicht lichtempfindliche Einheiten enthalten, die von kondensationsfähigen Verbindungen, insbesondere aromatischen Aminen, Phenolen, Phenolethern, aromatischen Thioethern, aromatischen Kohlenwasserstoffen, aromatischen Heterocyclen oder organischen Säureamiden, abgeleitet sind. Diese Kondensationsprodukte sind in der DE-C 20 24 244 beschrieben. Allgemein sind alle Diazoniumsalz-Polykondensationsprodukte geeignet, die in der DE-A 27 39 774 beschrieben sind.

Die Diazoniumsalzeinheiten A-N₂X leiten sich bevorzugt von Verbindungen der Formel (R¹-R³-)ₚR²-N₂X ab, wobei
- X: das Anion der Diazoniumverbindung,
- p: eine ganze Zahl von 1 bis 3,
- R¹: einen aromatischen Rest mit mindestens einer zur Kondensation mit aktiver Carbonylverbindung befähigten Position,
- R²: eine Phenylengruppe,
- R³: eine Einfachbindung oder eine der Gruppen:

-(CH₂)_{q}-NR⁴-,

-O-(CH₂)ᵣ-NR⁴-,

-S-(CH₂)ᵣ-NR⁴-,

-S-(CH₂)O-NR⁴-,

-O-R⁵-O-,

- O -

- S - oder

-CO-NR⁴-

bedeuten, worin
- q: eine Zahl von 0 bis 5,
- r: eine Zahl von 2 bis 5,
- R⁴: Wasserstoff, eine Alkylgruppe mit 1 bis 5 C-Atomen, eine Aralkylgruppe mit 7 bis 12 C-Atomen oder eine Arylgruppe mit 6 bis 12 C-Atomen, und
- R⁵: eine Arylengruppe mit 6 bis 12 C-Atomen ist.

Von den genannten Verbindungsklassen werden die Kondensationsprodukte der Diphenylamin-4-diazoniumsalze, die gegebenenfalls durch Alkyl-, Alkoxygruppen oder Halogenatome substituiert sind, bevorzugt. Als Zweitkomponenten B werden die gegebenenfalls substituierten Diphenylether, Diphenylsulfide, Diphenylmethane oder Diphenyle bevorzugt. Dabei werden für die Kondensation die Bis-methoxymethyl-, Bis-hydroxymethyl- oder Bis-acetoxymethylderivate der Grundkörper mit besonderem Vorteil eingesetzt. Das Kondensationsprodukt kann im Mittel 0,1 bis 50, bevorzugt 0,2 bis 20 Einheiten B je Einheit A-N₂X enthalten.

Der Mengenanteil des Diazoniumsalz-Polykondensationsprodukts in dem Gemisch liegt im allgemeinen zwischen 5 und 60, vorzugsweise zwischen 10 und 40 Gew.-%, bezogen auf den Gesamtgehalt an nichtflüchtigen Bestandteilen.

Weitere besonders vorteilhafte Polykondensationsprodukte werden erhalten, indem ein ggf. substituiertes Diphenylamindiazoniumsalz zuerst mit einer aromatischen Verbindung R'-O-CH₂-B und danach mit einer aromatischen Verbindung R'-O-CH₂-B-CH₂-O-R' kondensiert wird, wobei R' ein Wasserstoffatom, ein Alkyl- oder aliphatischer Acylrest ist. Diese Kondensationsprodukte sind in der EP-A 126 875 beschrieben.

Als radikalisch polymerisierbare Verbindungen werden bevorzugt Acryl- oder Methacrylsäureester von mehrwertigen, insbesondere primären Alkoholen eingesetzt. Die Alkohole können 2 bis 6, bevorzugt 2 bis 4 OH-Gruppen enthalten. Es können auch kleinere Mengen (Meth)acrylester einwertiger Alkohole im Gemisch enthalten sein. Beispiele für geeignete Ester sind Trimethylolpropantriacrylat, Pentaerythrittri- und -tetraacrylat, Propylenglykolmonomethacrylat, Glycerindimethacrylat, Triethylenglykoldimethacrylat, Polyethylenglykolmonoacrylat und Mono- oder Bisacrylate von oxyethylierten Bisphenol-A-Derivaten. Bevorzugt werden Monomere, die entweder eine freie OH-Gruppe oder eine Aminogruppe enthalten. Beispiele sind Diethylenglykolmonomethacrylat, Glycerinmono- und diacrylat und Umsetzungsprodukte von Triethanolamin und Glycidylmethacrylat. Es sind auch Urethangruppen enthaltende Acrylate und Methacrylate geeignet. Die Menge an polymerisierbaren Verbindungen liegt im allgemeinen zwischen 5 und 60, bevorzugt bei 10 bis 40 Gew.-%.

Als Photoinitiatoren können eine Vielzahl von Verbindungen, gegebenenfalls auch Gemische von zwei oder mehreren verschiedenen, oftmals synergistisch wirkenden Verbindungen Verwendung finden. Beispiele sind Benzoin und seine Derivate, Mehrkernchinone, Acridinderivate, z. B. 9-Phenyl-acridin, 9-p-Methoxyphenyl-acridin, Benz(a)acridin; Phenazinderivate, z. B. 9,10-Dimethylbenz(a)phenazin, 10-Methoxy-benz(a)phenazin; Chinoxalinderivate, z. B. 6,4',4''-Trimethoxy-2,3-diphenylchinoxalin, 4',4''-Dimethoxy-2,3-diphenyl-5-azachinoxalin; aromatisch substituierte Bis-trichlormethyl-s-triazine, z. B. 2-Naphth-1-yl-4,6-bis-trichlormethyl-, 2-Acenaphthyl-4,6-bis-trichlormethyl-, 2-(4-Ethoxyethoxy-naphth-2-yl)-4,6-bis-trichlormethyl- und 2-(4-Styryl-phenyl)-4,6-bis-trichlormethyl-s-triazin, oder trichlormethylsubstituierte Carbonylmethylenheterocyclen, z.B. 2-(p-Trichlormethyl-benzoylmethylen)-3-ethyl-benzthiazolin. Die Trichlormethylverbindungen werden besonders bevorzugt. Die Menge des Photoinitiators liegt im allgemeinen zwischen 0,05 und 10, bevorzugt zwischen 0,5 und 5 Gew.-%.

Die lichtempfindliche Schicht enthält vorzugsweise noch ein polymeres Bindemittel. Als Bindemittel kommen vorzugsweise wasserunlösliche Polymere, wie Epoxyharze, Harnstoff- und Melaminharze, Ketonharze, Vinylacetathomo- und -copolymere, Polyvinylacetale, z. B. Polyvinylformale oder Polyvinylbutyrale; Polyurethane, Polyacrylate, Polymethacrylate und Celluloseester in Betracht. Von den genannten Polymeren werden die Polyvinylacetale, insbesondere solche, die noch freie Vinylalkohol- und Vinylestereinheiten enthalten, bevorzugt.

Es können auch Bindemittel verwendet werden, die in Wasser unlöslich, aber in wäßrig-alkalischen Lösungen löslich sind. Derartige Bindemittel sind Phenolharze, Polyvinylphenole, Polysulfonylurethane, Acryl- und Methacrylsäurecopolymere, Styrol/Maleinsäureanhydrid-Copolymere und Umsetzungsprodukte von OH-Gruppen enthaltenden Polymeren, insbesondere Vinylalkoholeinheiten enthaltenden Polymeren, mit Anhydriden mehrwertiger Carbonsäuren, insbesondere von Di- oder Tricarbonsäuren. Die zuletzt genannten Polymeren werden besonders bevorzugt. Sie sind in der EP-A 0 152 819 beschrieben.

Bevorzugt werden die Reaktionsprodukte mit Malein-, Phthal-, Bernstein- und 3-Oxa-glutarsäureanhydrid.

Als Hydroxygruppen enthaltende synthetische Polymere kommen insbesondere Polymere mit Vinylalkoholeinheiten, aber auch Epoxidharze und verseifte Epoxidharze, Copolymere von Allylalkohol oder höheren ungesättigten Alkoholen, Polyhydroxyalkylacrylate und -methacrylate und ähnliche Polymerisate in Betracht.

Zur Stabilisierung der lichtempfindlichen Schicht ist es vorteilhaft, dieser eine Verbindung mit Säurecharakter zuzusetzen. In Betracht kommen Mineralsäuren und starke organische Säuren, von denen Phosphorsäure, Schwefelsäure, Perchlorsäure, Borsäure oder p-Toluolsulfonsäure bevorzugt werden. Eine besonders gut geeignete Säure ist die Phosphorsäure.

Die lichtempfindlichen Gemische können ferner Farbstoffe und/oder Pigmente enthalten, die als Kontrastmittel wirken können. In Frage kommende Farbstoffe sind beispielsweise in den US-A 3 218 167 und 3 884 693 angegeben. Besonders geeignet sind z. B. Viktoriareinblau FGA, Renolblau B2G-H (C.I. 74160), Kristallviolett oder Rhodamin 6 GDN (C.I. 45160). Zur Erhöhung des Bildkontrastes nach dem Belichten können Metanilgelb (C.I. 13065), Methylorange (C.I. 13025) oder Phenylazodiphenylamin verwendet werden.

Die Schichtdicke der lichtempfindlichen Schicht beträgt im allgemeinen 0,2 bis 5, bevorzugt 0,5 bis 3 µm.

Auf die lichtempfindliche Schicht wird dann die Silikonkautschukschicht aufgebracht. Sie wird aus einer Lösung in einem unpolaren Lösungsmittel, z. B. aliphatischen oder aromatischen Kohlenwasserstoffen, aufgebracht, in dem sich die Bestandteile der lichtempfindlichen Schicht unter den Beschichtungsbedingungen praktisch nicht auflösen. Geeignete Silikonkautschuke sind in der EP-A 0 226 201 beschrieben.

Grundsätzlich ist jeder Silikonkautschuk geeignet, der ausreichend farbabweisend ist, um ein Drucken im Offsetdruck ohne Feuchtwasser zu erlauben. Als "Silikonkautschuk" soll im Rahmen dieser Erfindung entsprechend der Definition von Noll in "Chemie und Technologie der Silikone", Verlag Chemie, 1968, S. 332, ein hochmolekulares, im wesentlichen lineares Diorganopolysiloxan bezeichnet werden, während für die vernetzten bzw. vulkanisierten Produkte die Bezeichnung "Silikongummi" verwendet wird. In jedem Fall wird eine Silikonkautschuklösung auf die lichtempfindliche Schicht aufgebracht, getrocknet und dann vernetzt.

Als Silikonkautschuke sind Einkomponenten- und Mehrkomponententypen geeignet, wie sie z. B. in den DE-A 23 50 211, 23 57 871 und 23 59 102 beschrieben sind.

Die Einkomponenten-Silikonkautschuke basieren auf Polysiloxanen, die z. B. endständige Acetyl-, Oxim-, Alkoxy- oder Aminogruppen oder Wasserstoffatome enthalten. Im übrigen besteht das Polysiloxan im wesentlichen aus einer Dimethylpolysiloxankette. Die Methylgruppen können in geringerem Umfang auch durch andere Alkylgruppen, durch Halogenalkylgruppen oder substituierte oder unsubstituierte Arylgruppen ersetzt sein. Die endständigen funktionellen Gruppen sind leicht hydrolysierbar und härten bei Feuchtigkeitseinwirkung innerhalb von einigen Minuten bis Stunden aus.

Die Mehrkomponenten-Silikonkautschuke können durch Addition oder durch Kondensation vernetzbar sein. Die additionsvernetzbaren Typen enthalten im allgemeinen Polysiloxane mit Alkenylgruppen als Substituenten und solche mit an Silicium gebundenen Wasserstoffatomen. Sie werden in Gegenwart von Platinkatalysatoren bei Temperaturen oberhalb 50° C vernetzt. Sie haben den Vorteil, daß sie bei höherer Temperatur, z. B. um 100° C, schnell vernetzen. Dafür kann auch die Verarbeitungsdauer (Topfzeit) dieser Systeme relativ kurz sein.

Die durch Kondensation vernetzbaren Gemische enthalten Diorganopolysiloxane mit reaktionsfähigen Endgruppen, z. B. OH- und Acetoxygruppen. Diese werden mit reaktiven Silanen oder Oligosiloxanen in Gegenwart von Katalysatoren vernetzt. Auch diese Kombinationen reagieren relativ schnell und haben deshalb eine begrenzte Topfzeit.

Mit besonderem Vorteil werden durch Addition vernetzbare Mehrkomponenten-Silikonkautschuke eingesetzt, wie sie z. B. in der DE-A 26 54 893 beschrieben sind.

Diese bevorzugten Silikonkautschuke sind durch Addition vernetzbare Mehrkomponenten-Silikonkautschuke aus a) Diorganopolysiloxanen mit endständigen Si-Vinylgruppen; b) Organopolysiloxanen mit mindestens drei an Silicium gebundenen Wasserstoffatomen; c) Platinkomplexen von Vinylsiloxanen und d) einem Mittel, das die Anlagerung von an Silicium gebundenen Wasserstoffatomen an aliphatische Mehrfachbindungen bei Raumtemperatur verzögert.

Die Silikonkautschuke werden nach dem Aufbringen als Schicht in bekannter Weise durch Feuchtigkeitseinwirkung oder aus sich heraus bei Raumtemperatur oder erhöhter Temperatur zu einem in organischen Lösemitteln im wesentlichen unlöslichen Silikongummi vernetzt. Die fertige Silikongummischicht hat im allgemeinen eine Dicke von 1 bis 20, bevorzugt von 2 bis 10 µm. Wie bereits erwähnt, erfolgt die Beschichtung im allgemeinen aus unpolaren Lösemitteln, z. B. Paraffinkohlenwasserstoffen, die die darunterliegende lichtempfindliche Schicht wenig oder gar nicht lösen.

Schichten aus den genannten Diazoniumsalz-Kondensationsprodukten und den oben beschriebenen ethylenisch ungesättigten polymerisierbaren Verbindungen in Kombination mit Deckschichten aus den bevorzugten besonders resistenten und farbabweisenden Mehrkomponenten-Silikonkautschuken lassen sich leicht und sauber mit organischen Lösemitteln, ggf. auch unter Zusatz von Wasser, entwickeln.

Die erfindungsgemäßen Druckplatten mit lichtempfindlichen Schichten aus Diazoniumsalz-Polykondensationsprodukten und photopolymerisierbaren Gemischen aus polymerisierbaren Verbindungen und Photoinitiatoren weisen überraschenderweise eine höhere Lichtempfindlichkeit auf als Druckplatten, die Schichten aus nur einem dieser lichthärtbaren Systeme enthalten. Es ist nicht im einzelnen bekannt, worauf die im Ergebnis erzielte höhere praktische Lichtempfindlichkeit hier beruht, jedoch ist anzunehmen, daß hierfür die Haftung der belichteten lichtempfindlichen Schicht an der Silikongummischicht von wesentlicher Bedeutung ist. Die praktische Lichtempfindlichkeit von Druckplatten dieser Art ist deshalb nicht mit der Lichtempfindlichkeit von Platten zu korrelieren, die nur die entsprechende lichtempfindliche Schicht, aber keine Silikonschicht enthalten.

Ein weiterer Vorteil der erfindungsgemäßen Druckplatten für den wasserlosen Offsetdruck ist darin zu erblicken, daß im Gegensatz zu den bekannten Druckplatten mit reinen photopolymerisierbaren Schichten keine Sauerstoffbarriere in Form einer zusätzlichen Deckschicht oder Deckfolie erforderlich ist.

Als Schichtträger werden meist Metalle verwendet. Für Offsetdruckplatten können eingesetzt werden: walzblankes, mechanisch oder elektrochemisch aufgerauhtes und ggf. anodisiertes Aluminium, das zudem noch chemisch, z. B. mit Polyvinylphosphonsäure, Silikaten, Phosphaten, Hexafluorozirkonaten oder mit hydrolysiertem Tetraethylorthosilikat, vorbehandelt sein kann. Weitere geeignete Metalle sind Stahl und Chrom. Da es, im Gegensatz zu üblichen Flachdruckplatten, nicht erforderlich ist, daß die Trägeroberfläche hydrophil ist, können mit Vorteil auch Kupfer, Messing oder andere oleophile Metalle als Trägeroberfläche dienen. Ebenso können Kunststoffolien, wie Polyester-, Polycarbonat-, Polyimid- oder auch Celluloseacetatfolien verwendet werden, deren Oberfläche ggf. zur Erhöhung der Benetzbarkeit durch Druckfarbe vorbehandelt sein kann. Auch gummielastische Trägermaterialien sind geeignet; mit solchen Trägern kann auch im direkten Flachdruck gedruckt werden.

Das Trägermaterial dient bei den Druckformen, die aus dem erfindungsgemäßen Material hergestellt werden, im Gegensatz zu sonst üblichen Druckformen, als farbführendes Material. Die nach dem Belichten und Entwickeln stehengebliebene Silikongummischicht dient als Bildhintergrund und wirkt in trockenem Zustand farbabstoßend. Zum Druck können dabei sowohl übliche Druckfarben auf Ölbasis als auch spezielle hydrophile Druckfarben dienen, wie sie für den wasserlosen Offsetdruck sowie für den umgekehrten Offsetdruck entwickelt wurden und im Handel erhältlich sind. Da die meisten gebräuchlichen Schichtträgeroberflächen, z. B. aufgerauhtes oder anodisch oxydiertes Aluminium, stark hydrophil sind, werden hydrophile Druckfarben mit Vorteil eingesetzt.

Zur Entwicklung der belichteten Druckplatten werden bevorzugt Gemische von organischen Lösemitteln untereinander oder mit Wasser verwendet. Dabei wird ein Bestandteil gewählt, der die Silikongummischicht zu quellen vermag, und ein Bestandteil, der die unbelichtete lichtempfindliche Schicht selektiv auflöst. Beispiele für geeignete Entwickler sind Kombinationen von Paraffinkohlenwasserstoffen mit polaren Lösemitteln, wie Estern, Ketonen oder Alkoholen. Geeignet sind auch Kombinationen von mit Wasser mischbaren Lösemitteln, wie niederen Alkoholen oder Ketonen, und Wasser.

Im folgenden werden Beispiele für bevorzugte Ausführungsformen der Erfindung beschrieben. Wenn nichts anderes angegeben ist, sind Mengenverhältnisse und Prozentangaben auf das Gewicht bezogen. Vor den Ausführungsbeispielen werden die verwendeten Monomeren und die verwendete Silikonkautschuklösung beschrieben. Die Mengen werden im allgemeinen in Gewichtsteilen (Gt) angegeben.

### Verwendete Monomere

1. N-Methyl-diethanolamindimethacrylat
2. Triethanolamintrimethacrylat
3. Umsetzungsprodukt von 1 mol Triethanolamin und 3 mol Glycidylmethacrylat
4. Umsetzungsprodukt von 1 mol Triethanolamin und 3 mol Tolylendiisocyanat, weiter umgesetzt mit 3 mol Glycerin-1,3-dimethacrylat
5. Diethylenglykolmonomethacrylat
6. Glycerin-1,3-dimethacrylat
7. Hydroxyethylmethacrylat
8. Glycerinmonomethacrylat
9. Trimethylolpropantrimethacrylat

### Verwendete Silikonkautschuklösung

10 Gt eines Dimethylpolysiloxans mit endständigen Vinyldimethylsiloxaneinheiten und mit einer Viskosität von 7000 mPa·s bei 25° C wurden mit 0,025 Gt 2-Methyl-3-butin-2-ol, 0,03 Gt der unten beschriebenen Mischung aus Platinkomplex von Vinylsiloxan und Verdünnungsmittel, 0,09 Gt eines Mischpolymerisats aus 4 mol-% Trimethylsiloxan-, 72 mol-% Methylhydrogensiloxan- und 24 mol-% Dimethylsiloxaneinheiten mit einer Viskosität von 50 mPa·s bei 25° C und einem Gehalt von 1,36 % an Si gebundenen Wasserstoffs und 88,9 Gt eines Isoparaffingemisches mit dem Siedebereich 116-136 °C bei Normaldruck (Isopar E) vermischt. Die Mischung läßt sich bis zu 24 Stunden nach der Herstellung verarbeiten.

Die Platinkomplex-Mischung wurde wie folgt hergestellt: Zu einer Mischung aus 10 Gt H₂PtCl₆x6H₂O, 20 Gt 1,3-Divinyl-1,1,3,3-tetramethyldisiloxan und 50 Gt Ethanol wurden 20 Gt Natriumhydrogencarbonat gegeben.

Das Gemisch wurde 30 Minuten unter Rühren zum Sieden unter Rückfluß erhitzt, dann 15 Stunden stehengelassen und danach filtriert. Aus dem Filtrat wurden bei 16 mbar die flüchtigen Bestandteile abdestilliert. Als Rückstand wurden 17 Gt einer Flüssigkeit erhalten, die in Benzol gelöst wurde. Die Lösung wurde filtriert und aus dem Filtrat das Benzol abdestilliert. Der Rückstand wurde mit einem Dimethylpolysiloxan, das endständige Vinyldimethylsiloxaneinheiten hatte und eine Viskosität von 1,4 Pa·s bei 23° C aufwies, als Verdünnungsmittel in solcher Menge vermischt, daß das Gemisch 1 Gew.-% Platin, berechnet als Element, enthielt.

### Beispiel 1 (Vergleichsbeispiel)

Auf eine elektrolytisch aufgerauhte und anodisch oxydierte Aluminiumplatte wurde eine Lösung von
2,34 Gt des Diazoniumsalz-Kondensationsprodukts aus 1 mol 3-Methoxy-diphenylamin-4-diazoniumsalz und 1 mol 4,4'-Bis-methoxymethyldiphenylether, isoliert als Mesitylensulfonat,
1,56 Gt des Umsetzungsprodukts von 50 Gt eines Polyvinylbutyrals mit einem Molekulargewicht von 70000 bis 80000, das 71 % Vinylbutyral-, 2 % Vinylacetat- und 27 % Vinylalkoholeinheiten enthält, mit 4 Gt Maleinsäureanhydrid,
0,069 Gt H₃PO₄ (85 %) und
0,019 Gt Phenylazodiphenylamin in
96,012 Gt 2-Methoxy-ethanol
aufgebracht und 2 Minuten bei 100 °C getrocknet. Das Schichtgewicht betrug 1 g/m². Auf die Platte wurde eine Deckschicht aus der oben angegebenen Silikonkautschuklösung aufgebracht und zwecks Vernetzung 3 Minuten bei 110 °C getrocknet. Die Silikongummischicht hatte ein Schichtgewicht von 2,7 - 2,8 g/m².

### Beispiel 2 (Vergleichsbeispiel)

Statt des Diazoniumsalz-Kondensationsprodukts wurde das Monomere 8 in gleicher Gewichtsmenge verwendet. Außerdem wurden 0,21 Gt 2-(4-Ethoxy-naphth-1-yl)-4,6-bis-trichlormethyl-s-triazin zugegeben. Sonst wurde wie in Beispiel 1 verfahren.

### Beispiel 3 (Vergleichsbeispiel)

Es wurde wie in Beispiel 2 verfahren, jedoch wurde statt des Monomeren 8 das Monomere 6 eingesetzt.

### Beispiele 4 bis 11

Beschichtungslösungen wurden wie in Beispiel 1 hergestellt, jedoch wurden jeweils von der Gesamtmenge des Diazoniumsalz-KondensationsproduktS 0,78 Gt durch die gleiche Menge des in der Tabelle angegebenen Monomeren ersetzt, und es wurden 0,07 Gt der in Beispiel 2 angegebenen Triazinverbindung zugesetzt.

| Beispiel Nr. | Monomeres Nr. | Schichtgewicht |
|---|---|---|
| 4 | 1 | 1,0 |
| 5 | 2 | 1,3 |
| 6 | 3 | 1,0 |
| 7 | 4 | 1,1 |
| 8 | 5 | 1,0 |
| 9 | 6 | 1,1 |
| 10 | 7 | 1,0 |
| 11 | 8 | 1,0 |

Sonst wurde wie in Beispiel 1 verfahren.

Die so hergestellten Platten wurden jeweils 30, 50, 70 und 90 s mit einer Metallhalogenidlampe (5 kW) unter einer Vorlage belichtet. Als Vorlage wurde ein Halbton-Stufenkeil mit 12 Dichtestufen von jeweils 0,15 verwendet, beginnend mit der Dichte 0,15 in Stufe 1.

Die belichteten Platten wurden 6 Minuten in einer Entwicklerlösung mit einem oszillierenden Filz (Hub 4,8 mm, Oszillationsfrequenz 3000/min, Andruck 1500 N/m²) behandelt. Die Entwicklerlösung setzte sich folgendermaßen zusammen:
40 Gt Gemisch von Isoparaffinen mit dem Siedebereich von 176 - 188° C,
27 Gt Tripropylenglykol,
30 Gt Diethylenglykoldimethylether.

Die Platten wurden mit Wasser gespült und mit Druckfarbe eingefärbt. Das Ergebnis ist in der folgenden Tabelle angegeben. Sie zeigt die Anzahl der bei der Entwicklung nicht angegriffenen Stufen.

| Beispiel Nr. | Monomeres Nr. | Belichtungszeit (Sekunden) | | | |
|---|---|---|---|---|---|
| | | 30 | 50 | 70 | 90 |
| 1 (V) | - | 2-3 | 3-4 | 4-5 | 5 |
| 2 (V) | 8 | | | | < 1 |
| 3 (V) | 6 | | | | < 1 |
| 4 | 1 | 5 | 6 | 7 | 7-8 |
| 5 | 2 | 4 | 5 | 6 | 6-7 |
| 6 | 3 | 3-4 | 5 | 5-6 | 6-7 |
| 7 | 4 | 3 | 4 | 5 | 6 |
| 8 | 5 | 3 | 4-5 | 5-6 | 6 |
| 9 | 6 | 3 | 4 | 5 | 6 |
| 10 | 7 | 3 | 4-5 | 5-6 | 6 |
| 11 | 8 | 3 | 4-5 | 5-6 | 6 |

## Patentansprüche

1. Lichtempfindliche Druckplatte für den wasserlosen Offsetdruck aus einem Schichtträger, einer lichtempfindlichen, ein Diazoniumsalz-Polykondensationsprodukt enthaltenden Schicht und einer darüberliegenden, Druckfarbe abstoßenden Silikongummischicht, dadurch gekennzeichnet, daß die lichtempfindliche Schicht ferner eine radikalisch polymerisierbare Verbindung mit mindestens einer endständigen ethylenisch ungesättigten Gruppe und einem Siedepunkt bei Normaldruck oberhalb 100 °C und einen unter Einwirkung aktinischer Strahlung Radikale bildenden Polymerisationsinitiator enthält.

2. Lichtempfindliche Druckplatte nach Anspruch 1, dadurch gekennzeichnet, daß das Diazoniumsalz-Polykondensationsprodukt aus wiederkehrenden Einheiten A-N₂X und B besteht, die durch Zwischenglieder, vorzugsweise Methylengruppen, miteinander verbunden sind, die von kondensationsfähigen Carbonylverbindungen abgeleitet sind, wobei A der Rest einer mit Formaldehyd kondensationsfähigen aromatischen Diazoniumverbindung und B der Rest einer von Diazoniumgruppen freien, mit Formaldehyd kondensationsfähigen Verbindung, insbesondere eines aromatischen Amins, eines Phenols, Phenolethers, aromatischen Thioethers, eines aromatischen Kohlenwasserstoffs, einer aromatischen heterocyclischen Verbindung oder eines organischen Säureamids ist.

3. Lichtempfindliche Druckplatte nach Anspruch 2, dadurch gekennzeichnet, daß die Einheiten A-N₂X sich aus Verbindungen der allgemeinen Formel
(R¹-R³-)ₚR²-N₂X
ableiten, wobei
X das Anion der Diazoniumverbindung,
p eine ganze Zahl von 1 bis 3,
R¹ einen aromatischen Rest mit mindestens einer zur Kondensation mit aktiver Carbonylverbindung befähigten Position,
R² eine Phenylengruppe,
R³ eine Einfachbindung oder eine der Gruppen:
-(CH₂)_{q}-NR⁴-,
-O-(CH₂)ᵣNR⁴-,
-S-(CH₂)ᵣ-NR⁴-,
-S-CH₂CO-NR⁴-,
-O-R⁵-O-,
- O -
- S - oder
-CO-NR⁴-
bedeuten, worin
q eine Zahl von 0 bis 5,
r eine Zahl von 2 bis 5,
R⁴ Wasserstoff, eine Alkylgruppe mit 1 bis 5 C-Atomen, eine Aralkylgruppe mit 7 bis 12 C-Atomen oder eine Arylgruppe mit 6 bis 12 C-Atomen, und
R⁵ eine Arylengruppe mit 6 bis 12 C-Atomen ist.

4. Lichtempfindliche Druckplatte nach Anspruch 1, dadurch gekennzeichnet, daß die polymerisierbare Verbindung ein Acryl- oder Methacrylsäureester eines mehrwertigen Alkohols ist.

5. Lichtempfindlich Druckplatte nach Anspruch 4, dadurch gekennzeichnet, daß die polymerisierbare Verbindung mindestens eine freie OH-Gruppe oder mindestens eine Aminogruppe enthält.

6. Lichtempfindliche Druckplatte nach Anspruch 1, dadurch gekennzeichnet, daß die lichtempfindliche Schicht ferner ein polymeres Bindemittel enthält.

7. Lichtempfindliche Druckplatte nach Anspruch 6, dadurch gekennzeichnet, daß das Bindemittel ein Umsetzungsprodukt eines intramolekularen Anhydrids einer organischen Polycarbonsäure mit einem Hydroxylgruppen enthaltenden synthetischen Polymeren ist, das keine weiteren zur Umsetzung mit Säureanhydriden befähigten funktionellen Gruppen enthält.

8. Lichtempfindliche Druckplatte nach Anspruch 1, dadurch gekennzeichnet, daß die lichtempfindliche Schicht 10 bis 90 Gew.-% Diazoniumsalz-Polykondensationsprodukt und 5 bis 60 Gew.-% polymerisierbare Verbindung enthält.

9. Lichtempfindliche Druckplatte nach Anspruch 1, dadurch gekennzeichnet, daß die Silikongummischicht aus einem vernetzten Mehrkomponentenkautschuk vom Additionstyp besteht.

10. Lichtempfindliche Druckplatte nach Anspruch 1, dadurch gekennzeichnet, daß die lichtempfindliche Schicht eine Schichtdicke von 0,2 bis 5 µm und die Silikonkautschukschicht eine Schichtdicke von 1 bis 20 µm hat.

## Claims

1. Photosensitive printing plate for waterless offset printing comprising a layer support, a photosensitive layer containing a diazonium salz polycondensation product, and an overlying, printing ink-repellent silicone rubber layer, characterized in that the photosensitive layer furthermore contains a compound which can be polymerized by means of free radicals, contains at least one terminal ethylenically unsaturated group and has a boiling point at atmospheric pressure of above 100 °C, and a polymerization initiator which forms free radicals under the action of actinic radiation.

2. A photosensitive printing plate as claimed in claim 1, characterized in that the diazonium salt polycondensation product comprises recurring A-N₂X and B units which are linked to one another through bridging members, preferably methylene groups, which are derived from carbonyl compounds which are capable of condensation, where A is the radical of an aromatic diazonium compound which is capable of condensation with formaldehyde, and B is the radical of a diazonium group-free compound which is capable of condensation with formaldehyde, in particular of an aromatic amine, a phenol, a phenol ether, an aromatic thioether, an aromatic hydrocarbon, an aromatic heterocyclic compound or an organic acid amide.

3. A photosensitive printing plate as claimed in claim 2, characterized in that the A-N₂X units are derived from compounds of the general formula
(R¹-R³-)ₚ-R²-N₂X
where
X denotes the anion of the diazonium compound,
p denotes an integer from 1 to 3,
R¹ denotes an aromatic radical having at least one position which is capable of condensation with an active carbonyl compound,
R² denotes a phenylene group,
R³ denotes a single bond or one of the groups:
-(CH₂)_{q}-NR⁴-,
-O-(CH₂)ᵣ-NR⁴-,
-S-(CH₂)ᵣ-NR⁴-,
-S-CH₂CO-NR⁴-,
-O-R⁵-O-,
- O -
- S - or
-CO-NR⁴-
in which
q is a number from 0 to 5,
r is a number from 2 to 5,
R⁴ is hydrogen, an alkyl group having 1 to 5 carbon atoms, an aralkyl group having 7 to 12 carbon atoms or an aryl group having 6 to 12 carbon atoms, and
R⁵ is an arylene group having 6 to 12 carbon atoms.

4. A photosensitive printing plate as claimed in claim 1, characterized in that the polymerizable compound is an acrylate or methacrylate of a polyhydric alcohol.

5. A photosensitive printing plate as claimed in claim 4, characterized in that the polymerizable compound contains at least one free OH group or at least one amino group.

6. A photosensitive printing plate as claimed in claim 1, characterized in that the photosensitive layer furthermore contains a polymeric binder.

7. A photosensitive printing plate as claimed in claim 6, characterized in that the binder is a product of the reaction of an intramolecular anhydride of an organic polycarboxylic acid with a synthetic polymer which contains hydroxyl groups, but no further functional groups which are capable of reacting with acid anhydrides.

8. A photosensitive printing plate as claimed in claim 1, characterized in that the photosensitive layer contains 10 to 90 % by weight of diazonium salt polycondensation product and 5 to 60 % by weight of polymerizable compound.

9. A photosensitive printing plate as claimed in claim 1, characterized in that the silicone rubber layer comprises a crosslinked addition-type multicomponent caoutchouc.

10. A photosensitive printing plate as claimed in claim 1, characterized in that the photosensitive layer has a thickness of from 0.2 to 5 µm and the silicone caoutchouc layer has a thickness of from 1 to 20 µm.

## Revendications

1. Plaque d'impression photosensible pour l'impression offset non aqueuse, composée d'un support de couche d'une couche photosensible, contenant un produit de polycondensation de sel de diazonium, et d'une couche de caoutchouc silicone, répulsive envers l'encre d'imprimerie, superposée à la précédente, caractérisée en ce que la couche photosensible contient de plus un composé polymérisable par voie radicalaire ayant au moins un groupe doté d'une insaturation éthylénique à une de ses extrémités et d'un point d'ébullition de plus de 100°C sous la pression normale, et un initiateur de polymérisation formant des radicaux libres sous l'action d'un rayonnement actinique.

2. Plaque d'impression photosensible selon la revendication 1, caractérisée en ce que le produit de polycondensation de sel de diazonium est constitué d'unités A-N₂X et B récurrentes, liées les unes aux autres par des liaisons pontantes, de préférence, par des groupes méthylène, dérivées de composés carbonyle capables de se condenser, A étant le radical d'un composé diazonium aromatique capable de se condenser avec le formaldéhyde et B étant le radical d'un composé, dépourvu de groupes diazonium, capable de se condenser avec le formaldéhyde, en particulier, d'une amine aromatique, d'un phénol, d'un éther phénolique, d'un thioéther aromatique, d'un hydrocarbure aromatique, d'un composé aromatique hétérocyclique ou d'un amide d'acide organique.

3. Plaque d'impression photosensible selon la revendication 2, caractérisée en ce que les unités A-N₂X dérivent de composés de formule générale
(R¹-R³-)ₚ-R²-N₂X
dans laquelle
X représente l'anion du composé diazonium,
p est un nombre entier valant de 1 à 3,
R¹ représente un radical aromatique ayant au moins une position capable de se condenser avec un composé à carbonyle actif,
R² représente un groupe phénylène,
R³ représente une liaison simple ou l'un des groupes :
-(CH₂)_{q}-NR⁴- ,
-O-(CH₂)ᵣ-NR⁴- ,
-S-(CH₂)ᵣ-NR⁴- ,
-S-CH₂CO-NR⁴- ,
-O-R⁵-O- ,
-O- ,
-S- ou
-CO-NR⁴- ,
dans lesquels
q est un nombre valant de 0 à 5,
r est un nombre valant de 2 à 5,
R⁴ est un atome d'hydrogène, un groupe alkyle ayant de 1 à 5 atomes de carbone, un groupe aralkyle ayant de 7 à 12 atomes de carbone ou un groupe aryle ayant de 6 à 12 atomes de carbone,
et
R⁵ est un groupe arylène ayant de 6 à 12 atomes de carbone.

4. Plaque d'impression photosensible selon la revendication 1, caractérisée en ce que le composé polymérisable est un ester d'acide acrylique ou d'acide méthacrylique d'un polyol.

5. Plaque d'impression photosensible selon la revendication 4, caractérisée en ce que le composé polymérisable contient au moins un groupe OH libre ou au moins un groupe amino.

6. Plaque d'impression photosensible selon la revendication 1, caractérisée en ce que la couche photosensible contient de plus un liant polymère.

7. Plaque d'impression photosensible selon la revendication 6, caractérisée en ce que le liant est un produit de réaction d'un anhydride intramoléculaire dérivé d'un acide organique polycarboxylique,avec un polymère synthétique contenant des groupes hydroxyle mais ne contenant pas d'autres groupes fonctionnels capables de réagir avec des anhydrides d'acides.

8. Plaque d'impression photosensible selon la revendication 1, caractérisée en ce que la couche photosensible contient de 10 à 90% en poids de produit de polycondensation de sel de diazonium et de 5 à 60% en poids de composé polymérisable.

9. Plaque d'impression photosensible selon la revendication 1, caractérisée en ce que la couche de caoutchouc silicone est constituée d'un caoutchouc à plusieurs constituants, réticulé, de type produit d'addition.

10. Plaque d'impression photosensible selon la revendication 1, caractérisée en ce que la couche photosensible a une épaissuer valant de 0,2 à 5 µm et la couche de caoutchouc silicone a une épaisseur valant de 1 à 20 µm.
